# EUROPEAN PATENT APPLICATION

(11) **EP 2 546 019 A1**
(43) Date of publication of application: **16.01.2013**
(21) Application number: 11173493.5
(22) Date of filing: 11.07.2011
(51) Int. Cl.: B23K 26/073

(54) **Device and method for structuring solar modules using a laser**

(71) Applicant: Solneva SA, 3270 Aarberg (CH)
(72) Inventor: The designation of the inventor has not yet been filed
(74) Representative: Scheuzger, Beat Otto

(57) **Abstract**

The invention relates to a device and a method for structuring modules, in particular large format modules such as solar modules. This device comprises holding means for holding a module (SM) and at least one laser means for emitting a laser beam (CB, CB', FB') towards a surface of the module (SM) for structuring the module. A beam-shaping means (A) is positioned in the optical path of the laser beam (CB, CB', FB') between the laser means and the surface of the module (SM) to be structured.

## Description

### Technical Field

The invention relates to a device for structuring modules, in particular large format modules such as solar modules. More specifically, the invention relates to a device for structuring modules, in particular large format modules such as solar modules, comprising holding means for holding a module and at least one laser means for emitting a laser beam towards a surface of the module for structuring the module.

### Background Art

Large format electrical and electronic modules are becoming more and more important, namely in applications where the surface of the module is one of the major performance criteria. Typical large format modules of this kind are solar modules (sometimes referred to as solar panels) which are nowadays increasingly used for transforming sunlight energy into electricity. Generally speaking, a solar module is a packaged interconnected assembly of so-called solar cells. Basically, solar cells are solid state devices which are capable of using the photovoltaic effect (or internal photoelectric effect) for converting the energy of the sunlight into electricity.

Essentially, most solar cells make use of a photoactive material for absorbing light, thus converting photons into electron-hole pairs, then separating those electrons and holes in an electric field extending across some material interface (internal photoelectric effect) and finally transporting electrons to a first electrode through an electron-conducting material and holes to a second electrode through a hole-conducting material. Solar cells can be divided into different groups, based on the type of photoactive material they use. Currently, most solar cells use monocrystalline or polycrystalline silicon in a wafer form. However, the high cost of crystalline silicon wafers and the scarce availability of its raw material (the so-called polysilicon) has contributed to the increasing popularity of solar cells based on thin films of silicon and other materials (they are referred to as thin-film solar cells). In such solar cells, these thin films typically have a thickness in the range of micrometers or less.

The most commonly used materials in the manufacturing of thin-film solar cells are amorphous and microcrystalline silicon (a-Si, µ-Si), cadmium telluride (CdTe) and copper indium (gallium) diselenide (better known under the acronyms CIS or CIGS). These semiconductor layers are generally deposited onto either coated glass substrates or flexible substrates such as stainless steel sheets or polymers.

The manufacturing process of thin-film solar modules is generally as follows: The substrate (e.g. a glass plate) is first coated with a first conductive layer. Then, a laser scribing method is used in order to create thin grooves in this layer so that individual cells can be separated from each other. In the next step, a second layer, consisting of a semiconductor material, can be deposited on top of the previous layer. Then, the substrate is again brought into a machine for structuring modules, and the laser scribing method is again used for removing or altering certain parts of the second layer, before a third layer is applied to the module. Finally, a third laser scribing step is needed for finalising the solar module.

A typical method for structuring electronics or photovoltaics modules involves patterning of thin films on this substrate. Such patterning is preferably carried out using a pulsed laser beam having short pulse durations and high beam quality, i.e. a laser beam having a close-to-Gaussian transverse intensity profile, which enables small focal diameters and long focal depths to be combined, thus allowing both narrow patterning structures and large processing tolerances. (An "ideal" laser beam is commonly understood to have the following two mutually interdependent characteristics dictated by nature: firstly, the ideal beam has a Gaussian transverse intensity distribution profile and, secondly, the product of the beam waist diameter and the beam divergence angle is a minimum value.)

Depending on local laser beam intensity and the type of material to be removed, the laser beam directed at and impinging on the module surface to be patterned will cause material at the surface of the module to be locally removed by evaporation, sublimation or conversion to a plasma (laser ablation). However, the close-to-Gaussian beam profile of such preferred high quality laser beams has a very high intensity in the centre of the beam decreasing quite slowly to wide-spread low intensity wings in the periphery of the beam. Thus, only a certain part of the laser beam cross section will have enough intensity to exceed the ablation threshold.

If only a small area in the centre of the beam cross section exceeds the ablation threshold, there is a lot of incident energy in the peripheral area of the beam cross section which, rather than contributing to the desired ablation process, will be absorbed in the module material where it will cause local heating. This may typically cause undesirable changes in the module material in the vicinity of the ablated pattern, the so-called heat affected zone (HAZ).

If most of the area of the beam cross section exceeds the ablation threshold, there is too much incident energy in the centre area of the beam cross section which, in addition to causing the desired ablation process, may typically damage the module material underneath the ablated pattern. Such damage will negatively affect the performance of the substrate in the finally produced modules such as reduced efficiency, reduced lifetime, etc. in module solar cells.

### Disclosure of the Invention

It is thus an object of the invention to propose an improved device and method for structuring modules, in particular large format modules such as solar modules, which do not present the above-mentioned inconveniences and disadvantages of the prior art.

According to the invention, these and other objectives are primarily achieved through the features of the independent claims. In addition, further advantageous embodiments of the invention are presented in the dependent claims and the description.

More particularly, in order to achieve this object, the invention provides a device for structuring modules, in particular large format modules such as solar modules, comprising holding means for holding a module and at least one laser means for emitting a laser beam towards a surface of the module for structuring the module, wherein a beam-shaping means is positioned in the optical path of the laser beam between the laser means and the surface of the module to be structured.

This allows the above-mentioned typical close-to Gaussian laser beam profile to be modified in order to avoid or minimize the above-mentioned undesirable changes or damage to the module material.

Preferably, the beam-shaping means is associated with the laser means. More preferably, an individual beam-shaping means is associated with each laser means. Most preferably this individual beam-shaping means and laser means are associated in a fixed spatial relationship with each other. This allows the or each laser means and the associated beam-shaping means to be moved together as a laser and beam shaping unit relative to the module to be irradiated by the shaped laser beam.

Preferably, the optical path of the laser beam extends from the laser means through an optical path section and through a laser head to the surface of the module to be structured, and a beam shaping means is located in the optical path section and/or in the laser head.

In a first preferred embodiment variant, the beam-shaping means is a beam-shaping means for converting a laser beam having a first, transverse intensity distribution with a peak value in a centre region surrounded by peripheral evanescent regions, such as an approximate Gaussian transverse intensity distribution, as measured along a direction or "base line" transverse to the direction of beam propagation, into a laser beam having a second, converted transverse intensity distribution, as measured along said direction or "base line" transverse to the direction of beam propagation, where, starting from said first, transverse intensity distribution, at least a portion of the intensity in the peak centre region of said first intensity distribution is shifted towards at least one of the peripheral evanescent regions of said first intensity distribution.

First, this will significantly reduce the above-mentioned undesirable changes in the module material in the vicinity of the ablated pattern, the so-called heat affected zone (HAZ). Second, this will avoid or at least significantly reduce any of the above-mentioned potential damage to the module material underneath the ablated pattern.

The beam-shaping means may be a beam-shaping means for converting said laser beam having said first transverse intensity distribution into a laser beam having a flat-top transverse intensity distribution, as measured along a direction or "base line" transverse to the direction of beam propagation.

Preferably, the beam-shaping means comprises a multimode optical fibre supporting a multitude of transverse electromagnetic modes for the laser beam to be converted, said fibre constituting a portion of the optical path of the laser beam to be converted, thus causing mode mixing and averaging of the transverse laser beam intensity distribution. As a result, a flat-top intensity distribution approximation is achieved.

As an alternative, or in addition to, the above beam shaping, the beam-shaping means may comprise an optical fibre with an entrance region having a circular cross section, with an exit region having a rectangular cross section and with a transition region therebetween providing a transition from said circular cross section to said rectangular cross section, said fibre constituting a portion of the optical path of the laser beam to be converted. This change in boundary condition along the fibre length, per se, will again cause some averaging of the transverse laser beam intensity distribution or, if applied to a multimode fiber, will at least contribute to the above mode mixing and averaging of the transverse laser beam intensity distribution. As a result, an even better flat-top intensity distribution approximation may be achieved.

Using a multimode optical fibre has the additional benefit that high coupling efficiencies are possible and readily achievable due to the ease of lateral and longitudinal alignment between a laser source and the multimode optical fiber.

In a second preferred embodiment variant, the beam-shaping means is a beam-shaping means for converting said laser beam having said first transverse intensity distribution into a laser beam having a second, trough-like transverse intensity distribution, preferably having an "M-profile", with two peripheral shoulder portions each having a peak intensity (local maximum) and with one central bottom portion having an intensity which is less than the peripheral peak intensity (local minimum), as measured along a direction or "base line" transverse to the direction of beam propagation.

Again, this will have the same or similar beneficial effects as the first preferred embodiment. However, unlike the first preferred embodiment where a laser beam having an at least approximate flat-top intensity profile impinges on the module surface to be structured by laser ablation, this second preferred embodiment will compensate for some of the energy propagation effects (heat transfer, shock wave, etc) of the converted radiation energy of the impinging close-to-flat-top-profile laser beam. As a result, rather than the mere radiant intensity profile of the impinging laser beam, the actual energetic impact (thermal, mechanical, etc.) at the surface or within the top layers of the module to be structured will have this at least approximate flat-top impact profile. First, this will even better reduce the above-mentioned undesirable changes in the module material in the vicinity of the ablated pattern, the so-called heat affected zone (HAZ). Second, this will even better avoid or reduce any of the above-mentioned potential damage to the module material underneath the ablated pattern.

Preferably, the beam-shaping means comprises an optical element, such as an axicon, which is located in, or constitutes a portion of, the optical path of the laser beam to be converted, and will cause an at least approximate ring-shape intensity distribution.

As an alternative, or in addition, the beam-shaping means may comprise an optical system having refractive and/or diffractive elements, which is located in, or constitutes a portion of, the optical path of the laser beam to be converted, and will cause or contribute to an at least approximate ring-shape intensity distribution.

In the inventive device, the holding means is preferably a fluid-dynamic suction type holder such as a Bernoulli gripper. This type of holder permits high positioning accuracy, typically less than 50 µm, in the direction perpendicular to the module surface to be structured, i.e. the z-direction, which accuracy is necessary for accommodating the small focal depth of a laser beam having the converted intensity profile.

Preferably, the holding means and the laser heads are arranged in a way movable with respect to each other. More preferably, the holding means and the module held by it are kept in a fixed position while the laser heads, preferably together with the associated beam-shaping means, are moved relative to the stationary holding means and module within a plane extending in parallel to the module surface, i.e. within the x-y-plane, and with a close-to-constant distance between the laser heads beam exit and the planar module surface, i.e. with a close-to-constant difference along the z-direction.

Preferably, the at least one laser means or laser head is arranged in a way movable beneath or above the module. More preferably, the at least one laser means or laser head is arranged beneath the module. As a result, due to gravity, any solid or liquid particles that may result from the ablation process are less prone to spoil the module surface.

Preferably, the laser means comprises a pulsed laser providing laser pulses having pulse durations in the range of 100 fs to 100 ns, preferably in the range of 1 ns to 20 ns, and having focus beam diameters in the range of 10 µm to 100 µm, preferably in the range of 20 µm to 40 µm, and preferably operating in the wavelength range of 300 nm to 1600 nm. Using pulsed laser beams with pulse durations in the nanosecond range contributes to an efficient use of the laser ablation process by confining the ablation energy input to the small target material volume to be ablated while still further minimizing any of the above-mentioned undesirable side effects caused by uncontrolled propagation of thermal and mechanical energy beyond that target material volume. Thus, the combination of applying the laser beam in a spatially and temporally defined manner by beam shaping and beam pulsing not only enables the precision and quality of the module structuring to be greatly improved, but also helps reduce overall power consumption of the ablation process.

In another embodiment variant, the at least one laser means comprises a laser as an optical source and an optical fiber, coupled to said laser, as the optical path.

Preferably, the laser means and beam-shaping means are combined in a unit which includes miniaturized components such as optical fibers, refractive and diffractive optical elements and gradient-index lenses for laser-to fibre coupling and/or beam shaping. As an alternative, this laser and beam-shaping means may include an optical fibre comprising a first length of doped optical fibre constituting a laser medium and a second length of optical fibre constituting a wave guide for the laser light generated in the first length of optical fiber, thus not necessitating any laser-to-fiber coupling lens. Preferably, the beam-shaping means is constituted by an additional length of this optical fiber. In other words, the laser and beam shaping unit may include an optical fibre with a doped length of fibre for laser light generation and propagation as well as an undoped length of fibre for mere laser light propagation with a beam shaping element somewhere along the undoped length of fiber, preferably close to the laser light exit end of the fiber.

Also, in order to achieve the above object, the invention provides a method for structuring modules, in particular large format modules such as solar modules, using a device as defined in any one of the previous paragraphs, said method comprising steps for holding a module; emitting a laser beam towards a surface of the module for structuring the module; and shaping said laser beam by a beam-shaping means positioned in the optical path of the laser beam between the laser means and the surface of the module to be structured.

The foregoing and other objects, features and advantages of the invention are apparent from the following detailed description taken in combination with the accompanying drawings in which:
Fig. 1 is a schematic cross-sectional view of an optical set-up with an optical element for focusing a Gaussian laser beam in a prior art device for structuring modules;
Fig. 2 is a schematic cross-sectional view of an optical set-up of optical elements for creating a laser beam having a ring-shape profile in a device according to the invention for structuring modules;
Fig. 3 is a schematic cross-sectional view of an optical set-up of optical elements for creating a laser beam having a flat-top profile in a device according to the invention for structuring modules;
Fig. 4A is a schematic view of a first arrangement, for instance comprising the optical set-up shown in Fig. 2 or Fig. 3, integrated in a device according to the invention for structuring modules;
Fig. 4B is a schematic view of a modification of the first arrangement shown in Fig. 4A, integrated in a device according to the invention for structuring modules;
Fig. 5A is a schematic view of a second arrangement, for instance comprising the optical set-up shown in Fig. 2 or Fig. 3, integrated in a device according to the invention for structuring modules; and
Fig. 5B is a schematic view of a modification of the second arrangement shown in Fig. 5A, integrated in a device according to the invention for structuring modules;
Fig. 6 is a schematic side view of a device according to the invention for structuring modules, in particular large format modules, comprising any one of the individual elements, optical set-ups or arrangements shown in Fig. 2, Fig. 3, Fig. 4A, Fig. 4B, Fig. 5A, Fig. 5B.
Fig. 7 is a schematic side view of a device according to the invention for structuring modules, in particular large format modules, comprising any one of the individual elements, optical set-ups or arrangements shown in Fig. 2, Fig. 3, Fig. 4A, Fig. 4B, Fig. 5A, Fig. 5B.
Fig. 8 is a schematic side view of a device according to the invention for structuring modules, in particular large format modules, comprising any one of the individual elements, optical set-ups or arrangements shown in Fig. 2, Fig. 3, Fig. 4A, Fig. 4B, Fig. 5A, Fig. 5B.

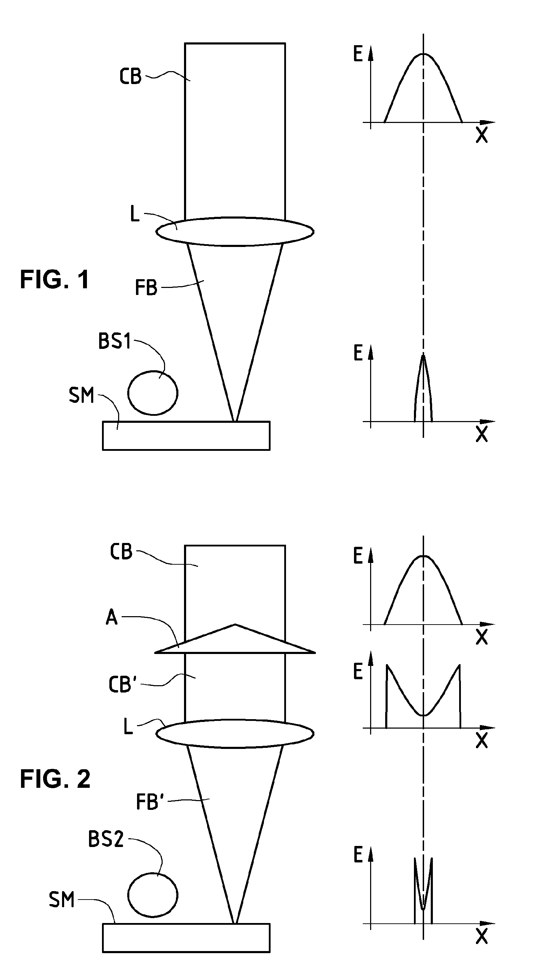

In Fig. 1, there is shown a schematic cross-sectional view of a known optical set-up with an optical element L for focusing a laser beam in a device 1 for structuring a solar module SM. In addition, Fig. 1 shows the transverse distribution of energy E along a base line with coordinate x perpendicular to the optical axis of beam propagation.

The optical element is a lens L positioned in the path of a collimated laser beam CB which has a close-to-Gaussian energy distribution, as indicated in the upper E versus x diagram next to the collimated laser beam CB. The collimated laser beam CB passes through the lens L, and is transformed into a focused laser beam FB, which still has a close-to-Gaussian, but narrower energy distribution, as indicated in the lower E versus x diagram next to the beam spot of the focused laser beam FB. The beam spot BS1, produced at the upper surface or, when operated in transmission mode, at the lower surface of the solar module SM by the focused laser beam FB impinging on the solar module SM, and the intensity distribution within this beam spot BS1 are schematically shown on an enlarged scale next to the focused laser beam FB. Brighter regions in the centre of beam spot BS1 indicate higher intensity, while darker regions in the periphery of beam spot BS1 indicate lower intensity.

When the focused laser beam FB with its beam spot BS1 is moved across a surface of the solar module SM, material is ablated from that surface along the line of passage of the focused laser beam FB and with a width corresponding to the diameter of the beam spot above the ablation threshold.

Clearly, most of the area of the cross section of beam spot BS1 exceeds the ablation threshold, and there is too much incident energy in the centre area of beam spot BS1, thus causing not only the desired ablation along the line with defined width, but also negatively affecting and possibly damaging the module material underneath the ablated line pattern. As mentioned above, such damage will negatively affect the performance of the substrate in the finally produced modules such as reduced efficiency, reduced lifetime, etc. in module solar cells.

In Fig. 2, there is shown a schematic cross-sectional view of an optical set-up with a first optical element A and a second optical element L for shaping and focusing a laser beam in a device 1 according to the invention for structuring a solar module SM. In addition, Fig. 2 again shows the transverse distribution of energy E along the base line with coordinate x perpendicular to the optical axis of beam propagation.

The first optical element A is an axicon lens (or simply "axicon") positioned in the path of the collimated laser beam CB which has the close-to-Gaussian energy distribution, as indicated in the uppermost first E versus x diagram next to the collimated laser beam CB. The collimated laser beam CB passes through the axicon A, and is transformed into a reshaped collimated laser beam CB' which has a ring-shaped energy distribution, as indicated in the second E versus x diagram next to the reshaped collimated laser beam CB'. This reshaped collimated laser beam CB' has a trough-like energy distribution with a minimum at the centre along the optical axis of collimated beam CB'.

The second optical element is a lens L (as in Fig. 1) positioned in the path of the reshaped collimated laser beam CB' which has the trough-like energy distribution. The reshaped collimated laser beam CB' passes through the lens L, and is transformed into a reshaped focused laser beam FB' which still has a trough-like, but narrower, energy distribution, as indicated in the lowermost E versus x diagram next to the beam spot BS2 of the reshaped focused laser beam FB'. The beam spot BS2, produced at the upper surface or, when operated in transmission mode, at the lower surface of the solar module SM by the reshaped focused laser beam FB' impinging on the solar module SM, and the intensity distribution within this beam spot BS2 are schematically shown on an enlarged scale next to the reshaped focused laser beam FB'. Darker regions in the centre of beam spot BS1 indicate lower intensity, while brighter regions in the periphery of beam spot BS1 indicate higher intensity.

When the reshaped focused laser beam FB' with its beam spot BS2 is moved across a surface of the solar module SM, material is ablated from that surface along the line of passage of the reshaped focused laser beam FB' and with a width corresponding to the diameter of the beam spot above the ablation threshold.

First, this will reduce the above-mentioned undesirable changes in the module material in the vicinity of the ablated pattern, i.e. reduce the heat affected zone (HAZ). Second, this will avoid or reduce any of the above-mentioned potential damage to the module material underneath the ablated pattern.

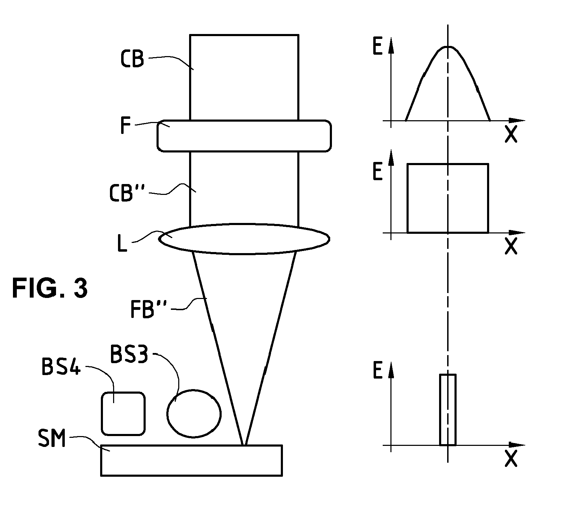

In Fig. 3, there is shown a schematic cross-sectional view of an optical set-up with a first optical element F and a second optical element L for shaping and focusing a laser beam in a device 1 according to the invention for structuring a solar module SM. In addition, Fig. 3 again shows the transverse distribution of the energy along the base line with coordinate x perpendicular to the optical axis of beam propagation.

The first optical element F is an optical system or optical tool for beam shaping arranged in, or forming a part of, the path of the collimated laser beam CB which has the close-to-Gaussian energy distribution, as indicated in the uppermost first E versus x diagram next to the collimated laser beam CB. Preferably, this optical beam shaping system comprises a multimode optical fibre with an entrance region having a circular cross section, with an exit region having a rectangular cross section and with a transition region therebetween providing a transition from the circular cross section to the rectangular cross section. This multimode optical fibre constitutes a portion of the optical path of the collimated laser beam CB to be converted. This change in boundary condition along the fibre length causes mode mixing and an averaging of the transverse laser beam intensity distribution. As a result, an approximate flat-top intensity distribution is achieved in the reshaped collimated laser beam CB".

The second optical element is a lens L (as in Fig. 1) positioned in the path of the reshaped collimated laser beam CB" which has the approximate flat-top transverse E field distribution. The reshaped collimated laser beam CB" passes through the lens L, and is transformed into a reshaped focused laser beam FB" which still has an approximate flat- top, but narrower energy distribution, as indicated in the lowermost E versus x diagram next to the beam spot BS4 of the reshaped focused laser beam FB". The beam spot BS4, produced at the upper surface or, when operated in transmission mode, at the lower surface of the solar module SM by the reshaped focused laser beam FB" impinging on the solar module SM, and the intensity distribution within this beam spot BS4 are schematically shown on an enlarged scale next to the reshaped focused laser beam FB". The centre of beam spot BS4 has approximately the same intensity as the periphery of beam spot BS4.

A particular and very advantageous feature of beam spot BS4 is its rectangular cross section which results from the rectangular cross section of the multimode fibre exit region. If a multimode fibre having a circular cross section throughout its length were chosen, the reshaped focused laser beam FB" of Fig. 3 would have a beam spot BS3 with a circular cross section.

When the reshaped focused laser beam FB" with its rectangular beam spot BS4 is moved across a surface of the solar module SM, material is ablated from that surface along the line of passage of the reshaped focused laser beam FB" and with a width corresponding to a diameter of the beam spot above the ablation threshold. Given the rectangular cross section of beam spot BS4 with its approximate flat-top profile, the beam spot BS4 can be aligned such that two of its sides are parallel to the line of passage and the other two sides are orthogonal to the line of passage. As a result, a well-defined and practically identical amount of energy will enter the material to be ablated.

First, this will reduce the above-mentioned undesirable changes in the module material in the vicinity of the ablated pattern, i.e. reduce the heat affected zone (HAZ). Second, this will avoid or reduce any of the above-mentioned potential damage to the module material underneath the ablated pattern.

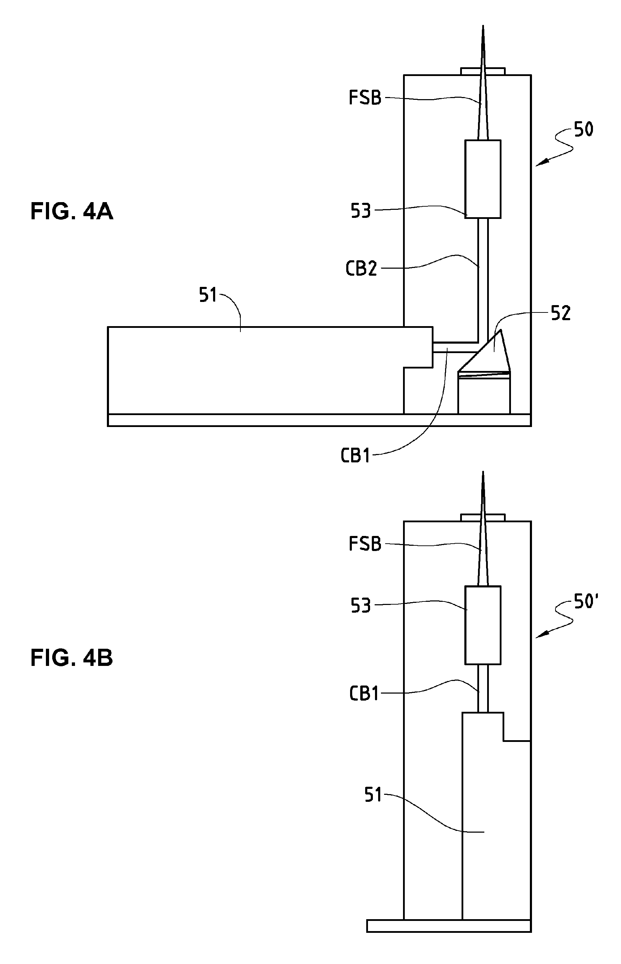

In Fig. 4A, there is shown a schematic view of a first arrangement 50, for instance comprising the optical set-up shown in Fig. 2 or Fig. 3, integrated in a device 1 according to the invention for structuring a solar module. This first arrangement 50 comprises a laser 51, a beam bender 52 and a beam shaping and focusing unit 53. Laser 51 produces a first collimated laser beam CB1 having a relatively large diameter. This first collimated laser beam CB1 is bent by beam bender 52, and propagates as a second collimated laser beam CB2 entering beam shaping and focusing unit 53, which produces a focused and reshaped laser beam FSB to be used for the ablation process. Preferably, laser 51 and the first arrangement 50 and in particular beam bender 52 are fixed in rigid relationship to each other. This prevents any misalignment between these elements even under dynamic loads that may cause vibrations of these elements.

In Fig. 4B, there is shown a schematic view of a modification 50' of the first arrangement 50, integrated in a device 1 according to the invention for structuring a solar module. This modified first arrangement 50' comprises a laser 51 and a beam shaping and focusing unit 53, but no beam bender. Again, laser 51 produces a first collimated laser beam CB1 having a relatively large diameter. This first collimated laser beam CB1 propagates and enters beam shaping and focusing unit 53, which produces a focused and reshaped laser beam FSB to be used for the ablation process. Preferably, this modified first arrangement 50' is used whenever sufficient space is available underneath the module to be structured, and it makes it possible to cut down on one optical element, which helps reduce the cost of equipment.

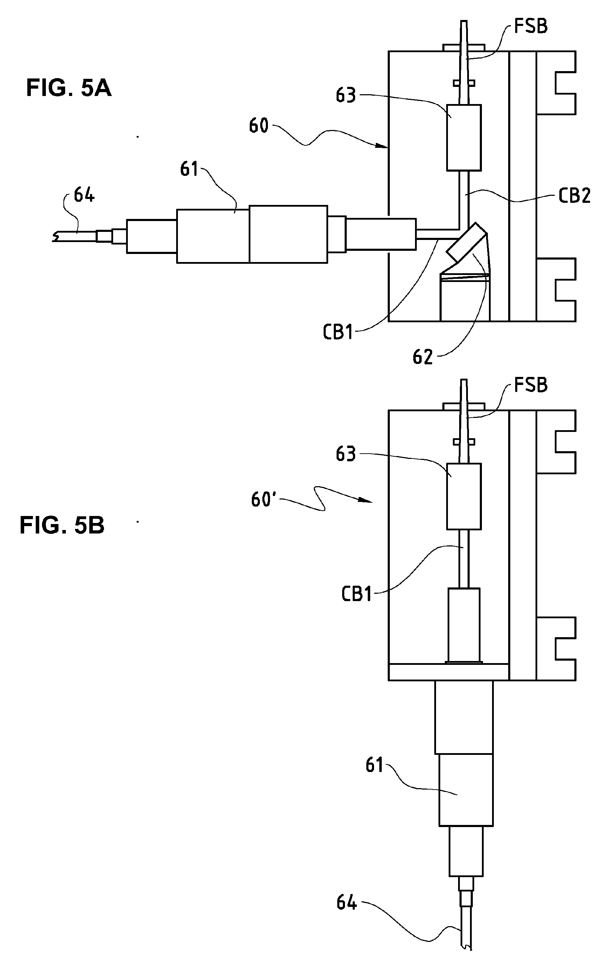

In Fig. 5A, there is shown a schematic view of a second arrangement 60, for instance comprising the optical set-up shown in Fig. 2 or Fig. 3, integrated in a device 1 according to the invention for structuring a solar module. This second arrangement 60 comprises a fibre head 61, a beam bender 62 and a beam shaping and focusing unit 63. Fibre head 61 is connected through a fibre 64 to a laser (not shown). Laser head 61 emits a first collimated laser beam CB1 having a relatively large diameter. This first collimated laser beam CB1 is bent by beam bender 62, and propagates as a second collimated laser beam CB2 entering beam shaping and focusing unit 63, which produces a focused and reshaped laser beam FSB to be used for the ablation process. Preferably, fibre head 61 and the second arrangement 60 and in particular beam bender 62 are fixed in rigid relationship to each other. This prevents any misalignment between these elements even under dynamic loads that may cause vibrations of these elements.

In Fig. 5B, there is shown a schematic view of a modification 60' of the second arrangement 60, integrated in a device 1 according to the invention for structuring a solar module. This modified second arrangement 60' comprises a fibre head 61 and a beam shaping and focusing unit 63, but again, no beam bender. Similarly to Fig. 5A, fibre head 61 is connected through a fibre 64 to a laser (not shown). Laser head 61 emits a first collimated laser beam CB1 having a relatively large diameter. This first collimated laser beam CB1 propagates and enters beam shaping and focusing unit 63, which produces a focused and reshaped laser beam FSB to be used for the ablation process. Again, this modified second arrangement 60' is preferably used whenever sufficient space is available underneath the module to be structured, thus making it possible to cut down on one optical element, which again helps reduce the cost of equipment.

In the arrangements of Figs. 5A and 5B, beam shaping may be carried out within the fiber 64 and/or within the beam shaping and focusing unit 63.

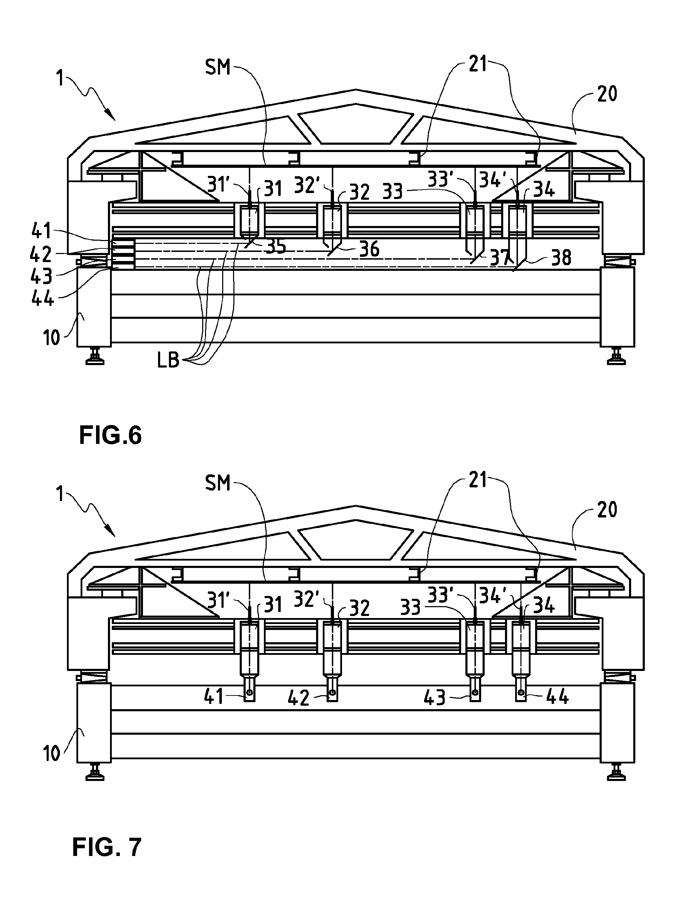

In Fig. 6, Fig. 7 and Fig. 8 schematic frontal views of two machines 1 for structuring thin-film solar modules SM are shown. In all these drawings, the structuring device itself bears the reference numeral 1. The device 1 comprises a chassis 10 and a holding means 20. The holding means 20 comprises a number of holding elements 21 which use a combination of vacuum and compressed air in order to keep the large format module (e.g. a thin film solar module) SM in a suspended state and ready to be machined. Details about the structure and the function of such devices should be well known to a skilled person.

As shown in Fig. 6, four laser sources 41, 42, 43, 44 are disposed on the frame 10 in such a way that they can provide the laser energy to the laser heads 31, 32, 33, 34 using a system of multiple mirrors 35, 36, 37, 38. Each of the multiple mirror systems 35, 36, 37, 38 is therefore positioned and oriented in such a way that it can receive and deliver the laser beam LB from the corresponding laser source 41, 42, 43, 44 to the solar module SM at any time.

Each of the laser heads 31, 32, 33, 34 comprises optical units 31', 32', 33', 34' which allow for focusing and shaping the laser beams coming out of the laser heads 31, 32, 33, 34. The optical units 31', 32', 33', 34' may include optical elements as shown in any one of Figs. 1, 2, 3, 4A, 4B, 5A and 5B.

The machine 1 shown in Fig. 6 corresponds to the arrangement shown in Fig. 4A with reference numerals 41, 42, 43, 44 in Fig. 6 each corresponding to reference numeral 51 in Fig. 4A; with reference numerals 35, 36, 37, 38 in Fig. 6 each corresponding to reference numeral 52 in Fig. 4A; and with reference numeral LB in Fig. 6 corresponding to reference numeral CB1 in Fig. 4A.

As shown in Fig. 7, four miniaturised laser sources 41, 42, 43, 44 are fully integrated into the laser heads 31, 32, 33, 34. Thus, a mirror system as in the previous case is not necessary.

Each of the laser heads 31, 32, 33, 34 comprises optical units 31', 32', 33', 34' which allow for focusing and shaping the laser beams coming out of the laser heads 31, 32, 33, 34. The optical units 31', 32', 33', 34' may include optical elements as shown in any one of Figs. 1, 2, 3, 4A, 4B, 5A and 5B.

The machine 1 shown in Fig. 7 corresponds to the arrangement shown in Figs. 4A or 4B with reference numerals 41, 42, 43, 44 in Fig. 7 each corresponding to reference numeral 51 in Figs. 4A or 4B.

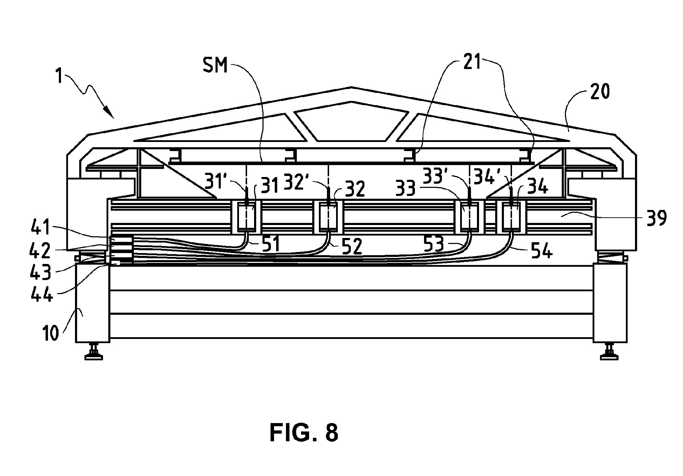

In Fig. 8, the structuring device itself bears the reference numeral 1. The device 1 comprises a chassis 10 and a holding means 20. The holding means 20 comprises a number of holding elements 21 which use a combination of vacuum and compressed air in order to keep the large format module (e.g. a thin film solar module) SM in a suspended state and ready to be machined. Details about the structure and the function of such devices should be well known to a skilled person.

The device 1 of Fig. 8 comprises four laser heads 31, 32, 33, 34 which are disposed beneath the large format module SM. It is obvious to a skilled person that the number of laser heads 31, 32, 33, 34 can be bigger or smaller than four. However, having four laser heads 31, 32, 33, 34 is a good compromise between the need to have different lines scribed at the same time and the need to allow space for quick movements of laser heads 31, 32, 33, 34, as well as the cost of laser sources.

Laser heads 31, 32, 33, 34 have movement means (not illustrated) which allow them to move beneath the large format module SM such that they can structure the surface of the module SM. In particular, laser heads 31, 32, 33, 34 can be mounted on a beam or girder 39 which can move in a first direction. In addition, each of the laser heads 31, 32, 33, 34 can move on the beam or girder 39 in a second direction which is perpendicular to the movement direction of the beam. However, any other appropriate movement system can be used in the device 1. In particular, a system is also possible in which each laser head 31, 32, 33, 34 is connected to an arm that is fully pivotable in all three spatial directions.

Each of the laser heads 31, 32, 33, 34 comprises optical units 31', 32', 33', 34' which allow for focusing and shaping the laser beams coming out of the laser heads 31, 32, 33, 34. The optical units 31', 32', 33', 34' may include optical elements as shown in any one of Figs. 1, 2, 3, 4A, 4B, 5A and 5B.

In addition, the optical units 31', 32', 33', 34' may be remotely controlled dynamically, in such a way that the focus and shape of the laser beams can be dynamically adapted to different production phases.

The device 1 further comprises four laser sources 41, 42, 43, 44 which are fixedly disposed at the frame 10 - one corresponding to each laser head 31, 32, 33, 34. Of course, the number of laser sources 41, 42, 43, 44 can be bigger or smaller than four and not necessarily correspond to the number of laser heads 31, 32, 33, 34. Preferably, one single laser source will deliver laser beams for all laser heads 31, 32, 33, 34. However, the number of laser sources 41, 42, 43, 44 will usually correspond exactly to the number of laser heads 31, 32, 33, 34. The laser sources 41, 42, 43, 44 may be chosen to provide laser beams in any one of the ultraviolet and/or green and/or red light spectra. It is also imaginable, however, to have laser sources 41, 42, 43, 44 that can provide laser beams in different spectra.

Also, the laser sources 41, 42, 43, 44 may be adapted to provide pulsed laser beams, especially in the nanosecond, picosecond or femtosecond range. However, it is also possible to use laser sources 41, 42, 43, 44 whose output are non-pulsed laser beams. Advantageously, if the pulsed laser beams are used, the device 1 can comprise a modulation means (not illustrated) for modulating the pulse frequency of the laser beams as a function of the movement speed of the corresponding laser head 31, 32, 33, 34.

The laser sources 41, 42, 43, 44 of the device 1 are coupled to the laser heads 31, 32, 33, 34 by means of a fibre-based guide 51, 52, 53, 54. Preferably, one single laser source can be coupled to four laser heads 31, 32, 33, 34 by means of four fibre-based guides 51, 52, 53, 54. However, usually, and as illustrated in Fig. 8, one laser source 41, 42, 43, 44 is directly coupled to one corresponding laser head 31, 32, 33, 34. However, it is also conceivable to adapt the device 1 in such a way that one laser source 41, 42, 43, 44 is coupled to more than one laser head 31, 32, 33, 34 or that a multitude of laser sources 41, 42, 43, 44 is coupled to a single laser head 31, 32, 33, 34. Also, the coupling of the laser sources 41, 42, 43, 44 to the laser heads 31, 32, 33, 34 does not need to be direct because different auxiliary elements (such as amplifiers, etc.) can be used between the laser sources 41, 42, 43, 44 and the laser heads 31, 32, 33, 34.

The fibre-based guides 51, 52, 53, 54 are preferably glass fibres, e.g. optical fibres. Any standard optical fibres can be used. However, a single-mode optical fibre, especially a large mode area (LMA) fibre, has got particular advantages for the present invention. It is conceivable that all fibre-based laser guides 51, 52, 53, 54 of the device 1 are of the same type. However, different guide types can obviously be used for any one of the fibre-based guides 51, 52, 53, 54.

The machine 1 shown in Fig. 8 corresponds to the arrangement shown in Figs. 5A or 5B with reference numerals 51, 52, 53, 54 in Fig. 8 each corresponding to reference numeral 64 in Figs. 5A or 5B.

Thanks to the device 1 for structuring large format modules according to the present invention, the machining process can be extremely optimised and the production quality of modules increased. Furthermore, the robustness of the device 1 makes it also usable in difficult environments. Thanks to the fibre-guided laser beams, the whole installation and adjustment process can be kept easy and quick which, again, increases the productivity of the device 1. In addition, the scribing preciseness leads to smaller dead zones which directly results in an increase in the efficiency of the modules.

Although the present disclosure has been described with reference to particular means, materials and embodiments, one skilled in the art can easily ascertain from the foregoing description the essential characteristics of the present disclosure, while various changes and modifications may be made to adapt the various uses and characteristics as set forth in the following claims.

## Claims

1. Device (1) for structuring modules, in particular large format modules such as solar modules (SM), comprising holding means (20) for holding a module (SM), at least one laser means (41, 42, 43, 44) for emitting a laser beam (CB, LB) towards a surface of the module for structuring the module, **characterized in that** a beam-shaping means (A; F) is positioned in the optical path of the laser beam (CB) between the laser means (41, 42, 43, 44) and the surface of the module (SM) to be structured.

2. Device (1) according to claim 1, **characterized in that** the optical path of the laser beam (CB) extends from the laser means (41, 42, 43, 44) through an optical path section (LB; 51, 52, 53, 54) and through a laser head (31, 32, 33, 34) to the surface of the module (SM) to be structured, and that a beam shaping means is located in the optical path section (LB; 51, 52, 53, 54) and/or in the laser head (31, 32, 33, 34).

3. Device (1) according to claim 1 or 2, **characterized in that** the beam-shaping means (A; F) is a beam-shaping means for converting a laser beam (CB) having a first, transverse intensity distribution with a peak value in a centre region surrounded by peripheral evanescent regions, such as an approximate Gaussian transverse intensity distribution, as measured along a direction or base line transverse to the direction of beam propagation, into a laser beam (CB'; CB") having a second, converted transverse intensity distribution, as measured along said direction or base line transverse to the direction of beam propagation, where, starting from said first, transverse intensity distribution, at least a portion of the intensity in the peak centre region of said first intensity distribution is shifted towards at least one of the peripheral evanescent regions of said first intensity distribution.

4. Device (1) according to claim 3, **characterized in that** the beam-shaping means is a beam-shaping means (F) for converting said laser beam (CB) having said first transverse intensity distribution into a laser beam (CB") having a flat-top transverse intensity distribution, as measured along a direction or base line transverse to the direction of beam propagation.

5. Device (1) according to claim 4, **characterized in that** the beam-shaping means comprises an optical fibre supporting the transverse energy distribution of the laser beam to be converted, said fibre constituting a portion of the optical path of the laser beam to be converted.

6. Device (1) according to claim 4 or 5, **characterized in that** the beam-shaping means comprises an optical fibre with an entrance region having a circular cross section, with an exit region having a rectangular cross section and with a transition region therebetween providing a transition from said circular cross section to said rectangular cross section, said fibre constituting a portion of the optical path of the laser beam to be converted.

7. Device (1) according to claim 3, **characterized in that** the beam-shaping means is a beam-shaping means (A) for converting said laser beam (CB) having said first transverse intensity distribution into a laser beam (CB') having a second, trough-like transverse intensity distribution, preferably having an "M-profile", with two peripheral shoulder portions each having a peak intensity or local maximum and with one central bottom portion having a lesser intensity or local minimum which is less than the peripheral peak intensity, as measured along a direction or base line transverse to the direction of beam propagation.

8. Device (1) according to claim 7, **characterized in that** the beam-shaping means (A) comprises an optical element, such as an axicon, said optical element constituting a portion of the optical path of the laser beam (CB) to be converted.

9. Device (1) according to claim 7 or 8, **characterized in that** the beam-shaping means comprises an optical system having refractive and/or diffractive elements, said optical system constituting a portion of the optical path of the laser beam to be converted.

10. Device (1) according to any one of claims 1 to 9, **characterized in that** the holding means is a fluid-dynamic suction type holder such as a Bernoulli gripper.

11. Device (1) according to any one of claims 2 to 10, **characterized in that** the holding means (20) and the laser heads (31, 32, 33, 34) are arranged in a way movable with respect to each other.

12. Device (1) according to claim 11, **characterized in that** the at least one laser means (41, 42, 43, 44) or laser head (31, 32, 33, 34) is arranged in a way movable beneath or above the module (SM).

13. Device (1) according to any one of claims 1 to 12, **characterized in that** the laser means comprises a pulsed laser providing laser pulses having pulse durations in the range of 100 fs to 100 ns, preferably in the range of 1 ns to 20 ns, and having focus beam diameters in the range of 10 µm to 100 µm, preferably in the range of 20 µm to 40 µm, and preferably operating in the wavelength range of 300 nm to 1600 nm.

14. Device (1) according to any one of claims 1 to 13, **characterized in that** the at least one laser means (41, 42, 43, 44) comprises a laser as an optical source and an optical fibre (51, 52, 53, 54; 64), coupled to said laser, as the optical path.

15. Method for structuring modules, in particular large format modules such as solar modules (SM), using a device (1) as defined in any one of claims 1 to 14, said method comprising: holding a module (SM); and emitting a laser beam (CB, CB', FB'; CB, CB", FB") towards a surface of the module (SM) for structuring the module, **characterized by** shaping said laser beam (CB, CB', FB'; CB, CB", FB") by a beam-shaping means (A; F) positioned in the optical path of the laser beam between the laser means and the surface of the module to be structured.
